# EUROPEAN PATENT APPLICATION

(11) **EP 1 667 266 A2**
(43) Date of publication of application: **07.06.2006**
(21) Application number: 05077089.0
(22) Date of filing: 15.09.2005
(51) Int. Cl.: H01M 8/02, H01M 8/10

(54) **A fuel cell having serial/parallel connecting mechanism of golden finger**

(30) Priority: 28.09.2004 CN 04296254 U
(71) Applicant: Antig Technology Co., Ltd., 114 Taipei (TW)
(72) Inventor: Shu, His-Ming, SinJhuang City Taipei (TW); Chang, Tsang-Ming, Taipei (TW); Deng, Feng-Yi, Taipei (TW); Shen, Ko-Chen, NeiHu Taipei (TW); Wang, Chien-Lang, BanCiao City Taipei (TW)
(74) Representative: De Pablos Riba, Julio

(57) **Abstract**

The present invention is a fuel cell having serial/parallel connecting mechanism of golden finger. The anode circuit board comprises anode current collection circuitries and one anode golden finger. The anode current collection circuitries are electrically connected to the anode golden finger. The cathode circuit board comprises cathode current collection circuitries and one cathode golden finger. The cathode current collection circuitries are electrically connected to the cathode golden finger. At least above one membrane electrode assembly (MEA) is close and sandwiched between the anode circuit board and the cathode circuit board, and again the MEAs are respectively one-by-one sandwiched between the anode current collection circuitries and the corresponding cathode current collection circuitries.

## Description

### FIELD OF THE INVENTION

The present invention is related to a fuel cell, especially to a fuel cell having serial/parallel connecting mechanism for serial/parallel connecting to each membrane electrode assembly (MEA).

### BACKGROUND OF THE INVENTION

The conventional fuel cell is to use serial/parallel connecting via holes as the means to serial/parallel connect each MEA, and although the fuel cell manufactured by the print circuit board (PCB) process using via hole means is convenient, the MEA itself being fragile and again processed by filling the conductive material into the via hole in the PCB process will damage the MEA in this stage as a result of having enormous impact to the yield of manufacturing the fuel cell.

The inventor investigates the disadvantages of the conventional fuel cell and desires to improve and invent a fuel cell having the golden finger placed along the board peripheral for serial/parallel connecting to the MEAs to overcome the above used disadvantages.

### SUMMARY OF THE INVENTION

The main object of the present invention is to provide a fuel cell having built-in serial/parallel connecting mechanism to possibly protect the MEAs from the damage in the process of serial/parallel connecting to each MEA.

To achieve the above object, the present invention provides a fuel cell having serial/parallel connecting mechanism of golden finger, comprising: the anode circuit board which comprises at least above one anode current collection circuitry and one anode golden finger wherein the anode golden finger comprises at least above one anode electrically connecting terminal and the anode current collection circuitries respectively one-by-one electrically connects to the anode electrically connecting terminals, the cathode circuit board comprises at least above one cathode current collection circuitry and one cathode golden finger wherein the cathode golden finger comprises at least above one cathode electrically connecting terminal and the cathode current collection circuitries respectively one-by-one electrically connects to the cathode electrically connecting terminals and also the placed positions of the cathode electrically connecting terminals and the placed positions of the anode electrically connecting terminals are one-by-one opposite, at least above one MEA is close and sandwiched between the anode circuit board and the cathode circuit board, and again the MEAs are respectively one-by-one sandwiched between the anode current collection circuitries and the corresponding cathode current collection circuitries.

The present invention design is innovative and useful in the industry for the improvement so as to apply and disclose the invention. In order to make the people familiar with the art understand the objects, characteristics and improvements, the present invention is detailed described in below by way of the following embodiments and attached figures.

### BRIEF DESCRIPTION OF THE DRAWINGS

These and other modifications and advantages will become even more apparent from the following detained description of a preferred embodiment of the invention and from the drawings in which:
Figure 1 shows the appearance figure of the present invention fuel cell having serial/parallel connecting mechanism of golden finger;
Figure 2 shows the decomposed figure of the fuel cell in FIG. 1;
Figure 3A shows the present invention fuel cell serial connecting to all MEAs, wherein the cathode serial/parallel connecting cooper circuitries located at the cathode circuit board are a layout example; and
Figure 3B shows the present invention fuel cell serial connecting to all MEAs, wherein the anode serial/parallel connecting cooper circuitries located at the anode circuit board are a layout example.

### DETAILED DESCRIPTION OF THE INVENTION

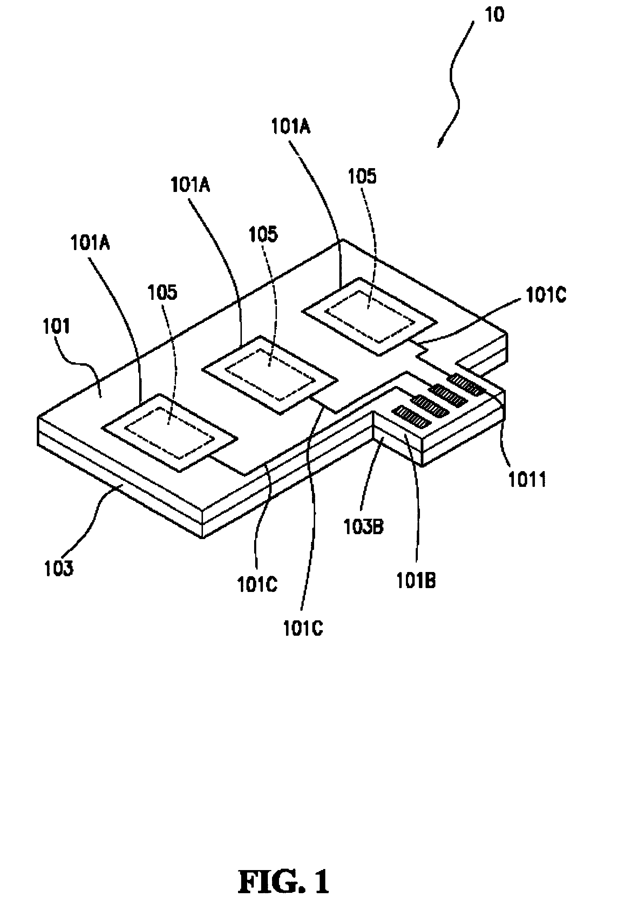

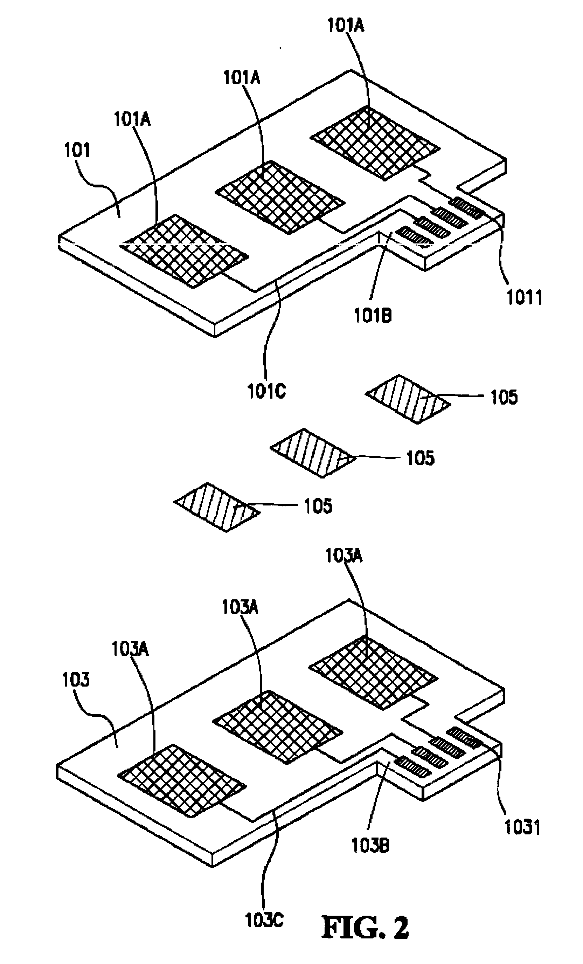

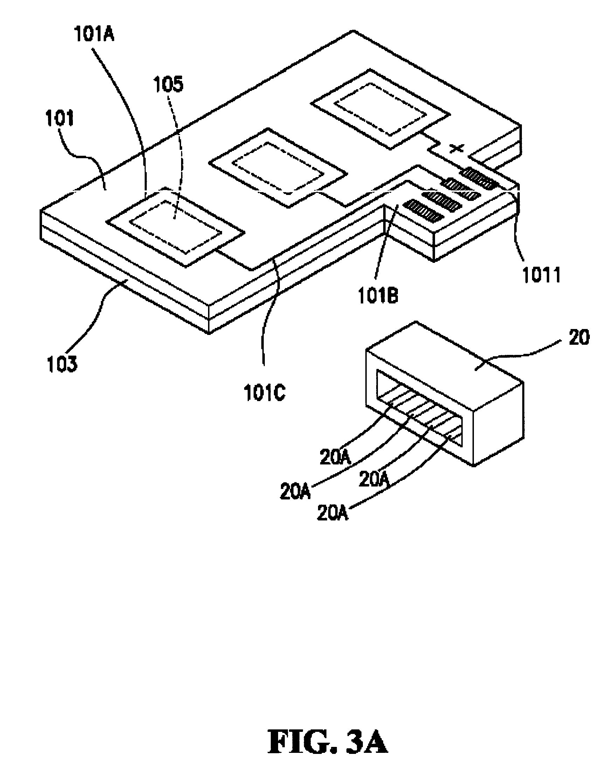

Figure 1 shows the appearance figure of the present invention fuel cell having serial/parallel connecting mechanism of golden finger and Figure 2 shows the decomposed figure of the fuel cell in FIG. 1. The present invention fuel cell 10 having serial/parallel connecting mechanism of golden finger mainly comprises cathode circuit board 101, anode circuit board 103 and at least above one membrane electrode assembly (MEA) 105. Cathode circuit board 101 and anode circuit board 103 are capable of using the PCB as the material and using the PCB process to form at least above one cathode current collection circuitry 101A, above one anode current collection circuitry 103A, cathode golden finger 101B, anode golden finger 103B, cathode serial/parallel cooper circuitries 101C and anode serial/parallel cooper circuitries 103C respectively on cathode circuit board 101 and anode circuit board 103, wherein cathode golden finger 101B comprises above one cathode electrically connecting terminal 1011, and anode golden finger 103B comprises above one anode electrically connecting terminal 103. The present invention places cathode golden finger 101B and anode golden finger 103B on one side of the peripheral of cathode circuit board 101 and anode circuit board 103 and extends them outward therefore to easily connect to connector 20 (referring to FIG. 3A). The present invention particularly places cathode electrically connecting terminals 1011 and anode electrically connecting terminals 1031 on up and down opposite sides and further uses cathode serial/parallel cooper circuitries 101C and anode serial/parallel cooper circuitries 103C to respectively connect each cathode current collection circuitry 101A one-by-one to each cathode electrically connecting terminal 1011 and connect each anode current collection circuitry 103A one-by-one to each anode electrically connecting terminal 1031.

In assembling the present invention fuel cell 10, it first respectively aligns and places each MEA 105 between each pair of up and down correspondingly opposite cathode current collection circuitry 101A and anode current collection circuitry 103A, and then piles sequentially in layer laminations of cathode circuit board 101, MEAs 105 and anode circuit board 103 together from top to down.

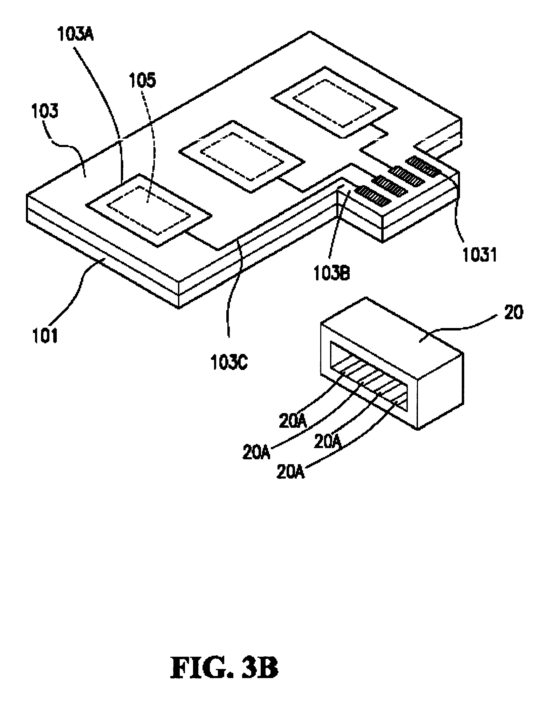

According to the future serial or parallel connecting art used for MEAs 105 in the plan of designing cooper circuitry connections, the present invention cathode serial/parallel cooper circuitries 101C and anode serial/parallel cooper circuitries 103C are able to be layout. Referring to FIG. 3A showing the present invention fuel cell serial connecting to all MEAs wherein the cathode serial/parallel connecting cooper circuitries 101C located at the cathode circuit board is a layout example and also referring to FIG. 3B showing the present invention fuel cell serial connecting to all MEAs wherein the anode serial/parallel connecting cooper circuitries 103C located at the anode circuit board is a layout example. The cathode serial/parallel cooper circuitries 101C and the anode serial/parallel cooper circuitries 103C are respectively serial connecting MEAs 105, cathode golden finger 101B and anode golden finger 103B. The present invention uses connector 20 to clip each pairs of cathode electrically connecting terminals 1011 and anode electrically connecting terminals 1031 on top and down opposite sides by each connecting pieces 20A and then electrically conducting. Connecting pieces 20A placed on connector 20 are possibly using U shape metallic piece for implementation. The notation of "+" in FIG. 3A denotes the positive electrode after serial connecting MEAs 105, and the notation of "-" in FIG. 3B denotes the negative electrode after serial connecting MEAs 105.

Those people skillful the art understanding the present invention is to implement the serial/parallel connecting mechanism for MEAs 105 by cathode electrically connecting terminals 1011 placed on cathode golden finger 101, anode electrically connecting terminals 1031 placed on anode golden finger 103, cathode serial/parallel copper circuitries 101C, anode serial/parallel cooper circuitries 103C and connector 20, and those people familiar with the art want to have any modification by changing the connections different from FIG. 3A and FIG. 3B, the modification still belongs to the present invention scope.

Furthermore, the present invention cathode current collection circuitries 101A and anode current collection circuitries 103A are possible to be respectively placed plural via holes (not shown in the figures) and make the cathode fuel and anode fuel respectively flow into cathode and anode of each MEA 105 by these via holes. The present invention cathode circuit board 101 and anode circuit board 103 are possible to use double-sided cooper PCB and respectively form cathode current collection circuitries 101 A and anode current collection circuitries 103A in up and down correspondingly and electrical conduction on the top surface and bottom surface.

The present invention fuel cell having serial/parallel connection mechanism of golden finger covers the following merits and significant improvements:
1. The present invention places cathode golden finger and anode golden finger in up and down opposite positions used for serial/parallel connecting MEAs respectively along the peripheral of cathode circuit board and anode circuit board to make serial/parallel connecting MEAs much easier; and
2. The present invention is totally different from the prior art using serial/parallel connecting MEAs by via holes, the prior art in the process of filling the solder or other conductive material into the via hole will damage the fuel cell, however, the present invention fully eliminates this disadvantage.

The above described embodiments are examples for convenient interpretations; the rights scope claimed by the present invention is based on the following claims and not limited by the above embodiments.

## Claims

1. A fuel cell having serial/parallel connecting mechanism of golden finger, comprising:
an anode circuit board, comprising at least above one anode current collection circuitry and an anode golden finger wherein the anode golden finger comprises at least above one anode electrically connecting terminal and the anode current collection circuitries respectively one-by-one electrically connect to the anode electrically connecting terminals;
a cathode circuit board, comprising at least above one cathode current collection circuitry and one cathode golden finger wherein the cathode golden finger comprises at least above one cathode electrically connecting terminal and the cathode current collection circuitries respectively one-by-one electrically connect to the cathode electrically connecting terminals and also the placed positions of the cathode electrically connecting terminals and the placed positions of the anode electrically connecting terminals are one-by-one opposite;
at least above one MEA, being close and sandwiched between the anode circuit board and the cathode circuit board, and again the MEA being respectively one-by-one sandwiched between the anode current collection circuitry and the corresponding cathode current collection circuitry.

2. The fuel cell having serial/parallel connecting mechanism of golden finger of claim 1, further comprising anode serial/parallel connecting circuitries which are formed on the anode circuit board and used for electrically connecting the anode current collection circuitries respectively one-by-one to the anode electrical terminals.

3. The fuel cell having serial/parallel connecting mechanism of golden finger of claim 1, further comprising cathode serial/parallel connecting circuitries which are formed on the cathode circuit board and used for electrically connecting the cathode current collection circuitries respectively one-by-one to the cathode electrical terminals.

4. The fuel cell having serial/parallel connecting mechanism of golden finger of claim 1, further comprising a connector which comprises at least above one connecting piece used to respectively connect and electrically conduct the cathode electrically connecting terminals and the anode electrically connecting terminals in one-by-one opposite pairing.

5. The fuel cell having serial/parallel connecting mechanism of golden finger of claim 4, wherein the connecting piece is a U shape metallic piece.
